Europäisches Patentamt

European Patent Office

Office européen des brevets

(19)

(11) Publication number: **0 259 011 B1**

# (12) EUROPEAN PATENT SPECIFICATION

(45) Date of publication of patent specification: **09.10.91**   (51) Int. Cl.⁵: **C08J 7/12, C08L 59/00**

(21) Application number: **87306884.5**

(22) Date of filing: **04.08.87**

(54) Method of surface treating a moulded polyacetal resin product.

(30) Priority: **06.08.86 JP 184669/86**

(43) Date of publication of application:
**09.03.88 Bulletin 88/10**

(45) Publication of the grant of the patent:
**09.10.91 Bulletin 91/41**

(84) Designated Contracting States:
**AT BE CH DE ES FR GB GR IT LI LU NL SE**

(56) References cited:
**DE-A- 2 108 475**
**GB-A- 2 091 274**
**US-A- 3 963 590**
**US-A- 4 464 435**

(73) Proprietor: **POLYPLASTICS CO. LTD.**
**30, Azuchimachi 2-chome**
**Higashi-ku Osaka-shi Osaka(JP)**

(72) Inventor: **Suzuki, Yoshiharu**
**324, Miyashita**
**Fuji-shi Shizuoka(JP)**
Inventor: **Akeda, Tomoyuki**
**885-11, Miyajima**
**Fuji-shi Shizuoka(JP)**

(74) Representative: **Jackson, Peter et al**
**HYDE, HEIDE & O'DONNELL 10-12 Priests**
**Bridge**
**London SW15 5JE(GB)**

**Description**

The present invention relates to a method of treating a surface of a moulded polyacetal resin product, in particular to a method of treating the surface of the moulded polyacetal resin product for efficiently obtaining its surface characteristics for surface decoration by means of printing, painting, vapour coating, plating and the like and for adhesion by means of adhesives.

Since polyacetal resins are remarkably stable against chemicals, being lacking in surface activity and having no suitable solvent, it is difficult for them to be subjected to the above-mentioned surface treatment. Accordingly, polyacetal resins have been hardly subjected to such surface treatment. However, in recent years not only mechanical, physical and chemical properties and functions but also special properties such as decorative properties and adhesive properties have been required for polyacetal resins in the diversification and advancement of their applications. In particular, in their applications as exterior parts a metallic surface property is required in many cases.

Methods of treating the surface of the moulded polyacetal resin product with phosphoric acid, p-toluene sulphonic acid, sulphuric acid and the like for improving its surface-processability, for example its surface-coating properties for plating, have been disclosed in US-A-3,235,426; 3,554,880; 3,905,877; and US-A-3,963,590. However, these methods face difficulties in giving the moulded polyacetal resin product a practically available surface-processability.

On the other hand, methods of roughening the surface of the moulded polyacetal resin product by adding substances, such as metal carbonates, which can be easily dissolved out with acids, and dissolving out the metal salts with acids after moulding have been disclosed in Japanese Patent Laid-Open No Sho 55-78023, Japanese Patent Laid-Open No Sho 55-92741 corresponding to US-A-4,464,435 and Japanese Patent Laid-Open No Sho 56-152845 as new methods of treating the surface of polyacetal resins. US patent specification US-A-3963590 discloses a method for electroplating a shaped polyoxymethylene article by the sequential steps of treating the article with quinoline or γ-butyrolactone; etching the surface of the article with an acid-etching agent such as o-phosphoric acid; neutralizing the etched surface of said article with a basic solution; and depositing metal coating(s) on the article.

These prior methods have led to the provision of moulded polyacetal resin products having practically available surface-processability. These methods have also shown problems, however, in the range of etching conditions for obtaining a moulded product having superior surface characteristics, in the advanced process control being required, and in the capacity of an etching solution being reduced both by change with the lapse of time and by contamination of the etching solution with metallic ions generated from the corrosion of the etching vessel or jigs, whereby the surface-processability, for example the adhesion of the plated layer, has been reduced. Accordingly, it has been desired to overcome these problems in the practical use of these methods in the industrial field.

The present inventors found that the above described object can be achieved by using an acidic solution comprising specified compounds added thereto as the etching solution comprising acidic substances, and achieved the present invention on the basis of the above described discovery.

The invention provides a method of treating a moulded article of polyacetal to roughen its surface, which comprises the step of etching the surface with an acidic solution comprising an acid selected from sulphuric, hydrochloric, phosphoric, acetic and p-toluene sulphonic acids and 0.2 to 100 g/l of a compound selected from an amine, a compound selected from an amine, an amide, a thiourea, a quinoline, a thioether, a thiol and an acetylenic alcohol. The above definition of the additive compound is classified into (a) a nitrogen-containing organic material such as an amine, an amide, a thiourea and a quinoline, (b) a sulphur-containing organic material such as a thiourea, a thioether and a thiol and (c) an unsaturated organic material such as an acetylenic alcohol.

In the invention, the acid may be used in a conventional amount.

That is to say, the present invention relates to a method of treating the surface of the moulded polyacetal resin product, characterised in that the etching process is carried out by the use of an acidic solution comprising an acid selected from sulphuric, hydrochloric, phosphoric, acetic and p-toluene sulphonic acids and 0.2 to 100 g/l of a at least one compound selected from a group consisting of amines, amides, thioureas, quinolines, thioethers, thiols and acetylenic alcohols. According to the present invention, not only are the range of etching conditions for obtaining the moulded product having the superior characteristics increased and the process control simplified but also the etching solution hardly shows any change with the lapse of time and reduction in capacity, whereby it becomes reliably possible to obtain a moulded product having superior surface-processability.

In the present invention sulphuric acid, hydrochloric acid and phosphoric acid are preferably used singly or in combination as main ingredients of the acidic solution (etching solution) and in addition, acidic

2

substances, such as acetic acid and p-toluene sulfonic acid, or oxidizing substances, such as chromic acid and chromates, may be added to these main ingredients.

The present invention is characterised by the following specified substances being added to the etching solution comprising the above described acidic substances. Thus, the above described object can be achieved and various kinds of effect and advantage can be obtained. That is to say, the specified substances to be added to the acidic etching solution according to the present invention include amines such as dimethylamine, trimethylamine, ethylamine, diethylamine, triethylamine, dibutylamine, propylamine, hexamethylenetetramine, xylidine, toluidine and N-butyl-diethanol amine; amides such as acetamide and dimethyl-formamide; thioureas such as thiourea, diethyl thiourea and dibutyl thiourea; quinolines such as quinoline, naphthoquinoline and phenylquinoline; thioethers such as propyl sulfide; thiols such as hexane thiol and mercaptobenzothiazole; and acetylenic alcohols such as propargyl alcohol, butyn diol and hexynol. At least one of these compounds is added at the ratio of 0.2 to 100 g based on one litre of the etching solution: the stabilised etching process cannot be achieved for a long time if they are added at a ratio smaller than 0.2 g based on one litre of the etching solution, and the etching process is hindered, such that the surface-processability is spoiled, if they are added to a ratio larger than 100 g based on one litre of the etching solution. They are preferably added to a ratio of 1 to 20 g/litre (etching solution).

In addition, in order to prevent bubbles from adhering to the surface of the moulded product during the etching process, surface active agents and the like may be added to the etching solution prepared in the above described manner.

Polyacetal resins used in the present invention are not specially limited. Polyacetal homopolymers, polyacetal copolymers, whose main chain mainly comprises oxymethylene chain, and these polyacetal resins modified by cross-linking or graft-copolymerizing using the known methods can be used as the polyacetal resins exhibiting the effects of the present invention. However, in order to roughen the surface of these polyacetal resins more efficiently and to obtain polyacetal resins having superior surface-processability, compounds selected from a group consisting of carbonates, phosphates, sulphates, acetates, silicates, hydroxides and oxides of the II-group metals of the Periodic Table of Elements, preferably calcium carbonate, are added to the polyacetal resins.

In view of physical properties of the polyacetal resins and the processability in plating and the like after the surface has been roughened, it is desired that these compounds have a mean particle diameter of 0.01 to 20 $\mu$m, preferably 0.1 to 10 $\mu$m, and are added at a ratio of 0.1 to 30%, preferably 0.5 to 10%, by weight base on the whole composite.

In addition, it is desired that the polyacetal resin composite used in the present invention further comprises known additives such as antioxidants and heat stabilizers.

Besides, known substances generally used in thermoplastic resins and thermosetting resins can be added to the polyacetal resins used in the present invention in dependence upon the use of the polyacetal resins so far as the roughening of the surface by etching, the surface-processability after the etching process and physical properties after the etching process are not remarkably spoiled.

Said known substances include organic high molecular substances, for example various kinds of stabilizer for improving light-resistance, weather-resistance and the like, lubricants, mould-releasing agents, plasticizers, nuclear agents, antistatic agents, surface active agents and the like; olefinic homo- or copolymers such as polyurethane resins, fluorine resins, polyethylene, polypropylene, ethylene-propylene copolymers, ethylene-vinyl acetate copolymers and ethylene-alkyl acrylate copolymers; vinylic compounds and copolymers thereof such as styrene-butadiene-acrylonitrile copolymers and styrene-acrylonitrile copolymers; polymers such as graft copolymers comprising polyacrylic resins, polyamide resins and thermoplastic segment type copolyesters; or modified substances starting therefrom; and fibrous, plate-like, granular and powdery inorganic compounds, such as glass fiber, metallic fiber, boron fiber, potassium titanate, ceramic, glass flake, glass beads, mica, talc, high dispersive silicate, alumina, aluminium hydroxide, silica sand, quartz sand, wollastonite, various kinds of metallic powder, metallic foil, silicon carbide, boron nitride and silicon nitride; whiskers; metallic whiskers and the like in addition to said antioxidants and the like.

In the etching process of the moulded product formed of such polyacetal resin composites with the acidic solution containing the above described specified compounds the optimum immersing conditions of the moulded product in the etching solution are suitably selected according to the properties of the etching solution but the generally preferable conditions are temperatures of 10 to 80 °C and treating times of 5 to 30 minutes.

In addition, in the present invention the moulded product can also be treated by the known methods before or after the etching process or both before and after the etching process. For example, the moulded product can be heated, treated with hot water or immersed in a solution containing specified compounds before or after the etching process. Such treatments which can be used after the etching process also include neutralization of the etching solution, washing and drying.

The present invention is more specifically described below with reference to the preferred embodiments and the comparative example. However, the present invention is not limited to them.

Preferred Embodiments 1 to 4 and Comparative Example 1

A flat plate (50 mm × 70 mm × 3 mm) was moulded from polyacetal resin containing calcium carbonate at a ratio of 3% by weight by means of injection moulding and adopted as a test piece.

The test piece was subjected to annealing at 145°C for one hour and then degreased at 60°C for 5 minutes by the use of ACE CLEAN A 220 (manufactured by Okuno Pharmaceutical Industries Co., Ltd.), and subsequently, subjected to the etching process. The acidic solutions comprising 98%-sulphuric acid, 85%-phosphoric acid and water at a ratio of 40/25/35 (by weight) with thiourea added at various concentrations as shown in Table 1 were used in the surface treatment. The surface treatment was conducted under the conditions as shown in Table 1.

Subsequently, the etched test piece was subjected to a plating process by the following method. At first, the etched test piece was neutralized with a 5 weight %-sodium hydroxide aqueous solution, washed, dried, immersed in a pretreatment solution for use in plating (CATALYST manufactured by Okuno Pharmaceutical Industries Co., Ltd.) at normal temperature for 3 minutes, immerse in an accelerator comprising 5 weight %-hydrochloric acid aqueous solution at 30°C for 5 minutes, washed and immersed in a chemical nickel plating solution (MTP chemical nickel plating solution manufactured by Okuno Pharmaceutical Industries Co., Ltd.) at 40°C for 12 minutes to chemically plate nickel.

The chemically plated test piece was further subjected to an electric plating, thermally treated at 80°C for one hour, stabilizing the adhesion and then the adhesion of the plated layer and the external appearance were evaluated. The former was evaluated by the conventional peel test at 10 mm width while the latter was visually judged on the basis of the destination of the reflected image under the light source of 300 luxes or more. On the other hand, for comparison, the similar test was conducted on a test piece obtained without adding thiourea to the etching solution. The evaluation results are shown in Table 1 together. In addition, the results as shown in Table 1 were considered from other angles with the results as shown in Table 2 and Table 3. That is to say, Table 2 shows a range of etching time capable of achieving an adhesion of 1.0 kg/cm or more and a mirror-finished surface when plated and Table 3 shows the maximum adhesion which can be reached with maintaining a mirror-finished surface when plated. Both Table 2 and Table 3 show that the effect of the addition of thiourea is remarkable.

Table - 1

| | Etching solution | | Evaluation item | Etching time (min)[1] at 40°C | | | | | | | | | | | | | | | | | |
| | Base | Quantity of thiourea added (g/l) | | 8 | 9 | 10 | 11 | 12 | 13 | 14 | 15 | 16 | 17 | 18 | 19 | 20 | 21 | 22 | 23 | 24 | 25 |
|---|---|---|---|---|---|---|---|---|---|---|---|---|---|---|---|---|---|---|---|---|---|
| **Samples** 1 | 98% - sulfuric acid/ 85% - phosphoric acid/ water = 40/25/35 (by weight) | 1 | External appearance*2 | O | O | | | O | O | Δ | Δ | | | | | | | | | | |
| | | | Adhesion (kg/cm) | 0.8 | 1.0 | | | 2.1 | 2.6 | 3.5 | 4.0 | | | | | | | | | | |
| 2 | " | 5 | External appearance*2 | O | O | | | O | | | O | Δ | | | | Δ | | | | | |
| | | | Adhesion (kg/cm) | 0.8 | 1.0 | | | 2.0 | | | 3.6 | 3.9 | | | | 4 | | | | | |
| 3 | " | 10 | External appearance*2 | | O | O | | O | | | O | O | O | Δ | | Δ | | | | | |
| | | | Adhesion (kg/cm) | | 0.8 | 1.0 | | 1.6 | | | 2.9 | 3.4 | 3.8 | 4 | | 4 | | | | | |
| 4 | " | 20 | External appearance*2 | | O | | O | O | | | O | | | | | O | O | O | O | | Δ |
| | | | Adhesion (kg/cm) | | 0.5 | | 0.9 | 1.9 | | | 1.7 | | | | | 2.5 | 2.8 | 3.0 | 3.2 | | 3.4 |
| **Comparative examples** 1 | " | - | External appearance*2 | O | O | | | O | Δ | | Δ | | | | | | | | | | |
| | | | Adhesion (kg/cm) | 0.7 | 1.0 | | | 2.3 | 2.8 | | 3.3 | | | | | | | | | | |

*1  Standard etching times are 9, 12, 15, 20 and 25 minutes.  However, in order to search for the limit treating time for achieving a mirror-finished surface when plated with maintaining an adhesion of 1.0 kg/cm or more when plated, the treatment was conducted also at times other than the above desribed times.

*2  O: Mirror-finished surface          Δ: Mirror-finished surface to an extent that an image slightly grows dim.

TABLE 1

Table - 2

| | | Quantity of thiourea added (g/ℓ) | Practical etching time[1] | |
|---|---|---|---|---|
| | | | Time (min) | Time range (min) |
| Examples | 1 | 1 | 9 - 13 | 4 · |
| | 2 | 5 | 9 - 15 | 6 |
| | 3 | 10 | 10 - 17 | 7 |
| | 4 | 20 | 12 - 23 | 11 |
| Comparative example | 1 | — | 9 - 12 | 3 |

[1] Etching time capable of achieving an adhesion of 1.0 kg/cm or more and a mirror-finished surface when plated.

| | | Quantity of thiourea added (g/ℓ) | Practical etching time[1] |
|---|---|---|---|
| Examples | 1 | 1 | 2.6 |
| | 2 | 5 | 3.6 |
| | 3 | 10 | 3.8 |
| | 4 | 20 | 3.2 |
| Comparative example | 1 | — | 2.3 |

[1] Maximum adhesion which can be reached with maintaining a mirror-finished surface when plated.

Examples 5 to 13 and Comparative Example 2

In these examples the effect of the addition of the specified compounds to the etching solution in the control of the deterioration after the use for a long time and the reduction in capacity of the etching solution was investigated.

The same test piece as in the above described examples 1 to 4 and Comparative Example 1 was used. The etching solution was prepared by adding the specified compounds as shown in Table 4 to an acidic solution comprising 98%-sulphuric acid, 36%-hydrochloric acid and water at a ratio of 47/13/40 (by weight). After the preparation of the etching solution, the test piece was etched in the etching solution, in which the appointed treatment (etching at a rate of 10 dm²/litre/day) has been continued for the appointed period, and plated. Its adhesion when plated was then measured.

In addition, for comparison, a similar test was conducted on a test piece obtained without adding these specified compounds to the etching solution. The procedures other than the etching process were conducted in the same manner as in the above described Examples 1 to 4 and Comparative Example 1. The results are shown in Table 4.

Table 4

| Additive*1 | | Adhesion when plated (kg/cm) | | | | |
|---|---|---|---|---|---|---|
| | | Immediately after the preparation of the etching solution | After three days*2 | After five days*2 | After ten days*2 | After fourteen days*2 |
| Example | 5 Thiourea | 3.0 | 2.7 | 2.6 | 2.3 | 2.1 |
| | 6 Diethyl thiourea | 3.1 | 2.8 | 2.6 | 2.4 | 2.1 |
| | 7 Trimethylamine hydrochloride | 3.0 | 2.6 | 2.5 | 2.1 | 2.0 |
| | 8 N-butyl-diethanolamine | 2.8 | 2.5 | 2.4 | 2.0 | 1.8 |
| | 9 Acetamide | 2.9 | 2.6 | 2.3 | 1.8 | 1.7 |
| | 10 2-mercaptobenzothiazole | 2.8 | 2.6 | 2.4 | 2.1 | 1.7 |
| | 11 Propargyl alcohol | 2.7 | 2.5 | 2.1 | 1.8 | 1.6 |
| | 12 2-phenyl-quinoline | 2.9 | 2.7 | 2.4 | 2.0 | 1.8 |
| | 13 Propyl sulfide | 3.0 | 2.6 | 2.4 | 1.9 | 1.7 |
| Comparative Example | 2 — | 3.0 | 2.8 | 2.1 | 1.3 | 1.0 |

*1: Added at a ratio of 5 g/liter (etching solution).

*2: Number of days after the preparation of the etching solution (meaning that the etching solution was used in the surface treatment after three days, five days, ten days and fourteen days from the preparation thereof).
The etching process was conducted at 25°C for 10 minutes.
In every case a mirror-finished surface was obtained after plating.

As is obvious from the above described description and Examples, the range of the effective etching conditions can be extended by etching the moulded polyacetal resin product in the acidic solution comprising the specified compounds such as amines, amides, thioureas, quinolines, thioethers, thiols and acetylenic alcohols, and harmful influences due to the change of the etching solution with a lapse of time can be suppressed. The surface of the moulded polyacetal resin product can be stably and easily roughened and superior surface-processability can be given to the moulded polyacetal resin product.

## Claims

1. A method of treating a moulded article of polyacetal resin to roughen its surface, which comprises the step of etching the surface with an acidic solution comprising an acid selected from sulphuric, hydrochloric, phosphoric, acetic and p-toluene sulphonic acids and 0.2 to 100 g/l of a compound selected from an amine, an amide, a thiourea, a quinoline, a thioether, a thiol and an acetylenic alcohol.

2. A method as claimed in claim 1, in which the main acidic ingredient of the solution is one or more of sulphuric, hydrochloric and phosphoric acids and the solution additionally contains oxidising substances or one or both of acetic and p-toluene sulphonic acids.

3. A method as claimed in claim 1 or claim 2, in which the polyacetal resin comprises a carbonate, a phosphate, a sulphate, an acetate, a silicate, a hydroxide or an oxide of a metal belonging to group II of the periodic table of elements.

**Revendications**

1. Un procédé de traitement d'un article moulé en résine polyacétal pour rendre sa surface rugueuse, qui comprend l'étape d' attaque de la surface par une solution acide comprenant un acide choisi parmi les acides sulfurique, chlorhydrique, phosphorique, acétique et p-toluène-sulfonique et 0,2 à 100 g/l d'un composé choisi parmi une amine, un amide, une thio-urée, une quinoléine, un thioéther, un thiol et un alcool acétylénique.

2. Un procédé tel que revendiqué dans la revendication 1, dans lequel le principal ingrédient acide de la solution est l'un ou plusieurs des acides sulfurique, chlorhydrique et phosphorique et la solution contient, de plus, des substances oxydantes ou l'un ou chacun des acides acétique et p-toluène-sulfonique.

3. Un procédé tel que revendiqué dans la revendication 1 ou la revendication 2, dans lequel la résine polyacétal comprend un carbonate, un phosphate, un sulfate, un acétate, un silicate, un hydroxyde ou un oxyde d'un métal appartenant au Groupe II du Tableau Périodique des Eléments.

**Patentansprüche**

1. Verfahren zum Behandlung eines Formgegenstandes aus Polyazetatharz um seine Oberfläche aufzurauen, welches das Ätzen der Oberfläche mit einer sauren Lösung umfaßt, welche Lösung eine Säure gewählt aus Schwefel-, Chlorwasserstoff-, Phosphor-, Essig- und p-Toluolsulfonsäure und 0,2 bis 100 g/l einer Verbindung gewählt aus einem Amin, einem Amid, einem Thioharnstoff, einem Chinolin, einem Thioether, einem Thiol und einem azetylenischen Alkohol enthält.

2. Verfahren nach Anspruch 1, in welchem der Hauptsäurebestandteil der Lösung eine oder mehrere der aus Schwefel-, Chlorwasserstoff- und Phosphorsäure gewählten Säuren ist und die Lösung zusätzlich oxidierende Substanzen oder eine oder beide Säuren, nämlich Essig- und p-Toluolsulfonsäure enthält.

3. Verfahren nach Anspruch 1 oder 2, in welchem das Polyazetatharz ein Karbonat, ein Phosphat, ein Sulfat, ein Azetat, ein Silikat, ein Hydroxid oder ein Oxid eines Metalls der II-Gruppe des Periodensy-stems der Elemente enthält.